# FASCICULE DE BREVET EUROPEEN

(11) **EP 2 840 617 B1**
(45) Date de publication et mention de la délivrance du brevet: **29.11.2017**
(21) Numéro de dépôt: 14181928.4
(22) Date de dépôt: 22.08.2014
(51) Int. Cl.: H01L 31/107, H01L 31/0232

(54) **Photodiode BSI à haut rendement quantique**
BSI-Fotodiode mit hoher Quanteneffizienz
BSI photodiode with high quantum efficiency

(30) Priorité: 23.08.2013 FR 1358141
(43) Date de publication de la demande: 25.02.2015
(73) Titulaire: COMMISSARIAT À L'ÉNERGIE ATOMIQUE ET AUX ÉNERGIES ALTERNATIVES, 75015 Paris (FR); STmicroelectronics SA, 92120 Montrouge (FR)
(72) Inventeur: Marty, Michel, 38760 Saint Paul de Varces (FR); Frey, Laurent, 38600 Fontaine (FR)
(74) Mandataire: Thibon, Laurent

(56) Documents cités:
- EP-A1- 1 785 750
- WO-A1-2012/032495
- US-A1- 2009 057 801
- US-A1- 2012 306 035
- US-A1- 2013 099 343

## Description

### Domaine

La présente demande concerne les diodes photorécep-trices ou photodiodes à semiconducteurs, utilisées par exemple comme pixels d'un capteur d'image.

### Exposé de l'art antérieur

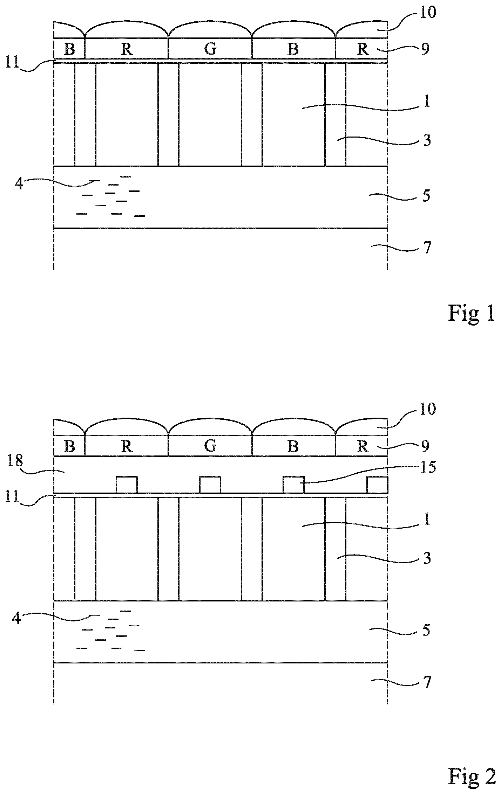

La figure 1 représente de façon simplifiée et partielle des photodiodes côte à côte d'un réseau de photodiodes constituant par exemple un capteur d'image. Chaque photodiode comprend une zone semiconductrice 1 de conversion de photons en paires électrons-trous. Dans une photodiode complète, il existe des jonctions (non représentées) entre des régions semiconductrices de type opposé pour stocker les électrons, et divers transistors de lecture pour transférer les électrons.

Plus particulièrement, la figure 1 illustre un réseau de photodiodes de type BSI (de l'anglais Back Side Illumination), c'est-à-dire à éclairement par la face arrière. Dans ce type de structure, les zones semiconductrices 1 ont couramment une épaisseur de seulement 2 à 5 µm. Les photodiodes 1 sont séparées par des régions isolantes 3, couramment désignées dans la technique par l'appellation DTI (Deep Trench Isolation), c'est-à-dire à isolement par tranchées profondes. En dessous de la couche semiconductrice contenant les photodiodes 1 sont formés divers niveaux de métallisation 4 noyés dans une succession de couches isolantes désignées globalement par la référence 5. L'ensemble repose sur un support ou poignée 7, couramment une tranche de silicium. Du côté supérieur, ou face arrière de la structure, chacune des photodiodes est surmontée d'un filtre 9 correspondant à la couleur que cette photodiode doit détecter. Les filtres, rouge, vert et bleu, sont désignés par les références R, G et B, (de l'anglais Red, Green et Blue). Chacun des filtres 9 est surmonté d'une microlentille 10. Entre les filtres 9 et la surface supérieure des couches semiconductrices 1 est généralement prévue une mince couche isolante 11, ou un assemblage de couches isolantes formant une structure antireflet.

La demande de brevet PCT WO2012/032495 expose que, quand les dimensions latérales de la surface éclairée d'une photodiode sont très faibles, de l'ordre de la longueur d'onde λ de la lumière que la photodiode est destinée à capter, ou longueur d'onde de fonctionnement, il se pose un problème pour introduire la lumière dans la photodiode. Ainsi, le rendement quantique de telles photodiodes de très petites dimensions est faible. Cette demande de brevet propose, pour augmenter le rendement quantique de la photodiode, de disposer sur la surface supérieure de celle-ci un plot dont les dimensions latérales sont inférieures aux dimensions latérales de la photodiode.

Cette demande de brevet précise que les photodiodes concernées sont du type FSI, de l'anglais Front Side Illumination, c'est-à-dire à éclairement par la face avant. Dans ce cas, il se pose des problèmes particuliers du fait que le réseau de métallisations se trouve du côté de la source d'éclairement. Comme on le verra ci-après, la structure proposée dans cette demande de brevet présente des inconvénients dans le cas de photodiodes de type BSI.

Ainsi, il se pose un problème pour absorber le maximum de photons possible dans des structures telles que celle représentée en figure 1, dans le cas de pixels de petites dimensions, c'est-à-dire dont les dimensions latérales sont de l'ordre de un à cinq fois la longueur d'onde de fonctionnement. Plus généralement, plus la surface de collection est petite, plus le rendement quantique du dispositif pose problème. Ce problème se pose plus ou moins dans toutes les photodiodes à semiconducteur.

On notera donc que, dans des photodiodes de très petites dimensions, une augmentation, même faible, du rendement quantique ou taux d'absorption de la partie utile de la photodiode est en pratique extrêmement importante pour la détection de lumière de faible intensité. Ainsi, un gain de rendement de 1 à 5 % sera considéré comme un gain important par l'utilisateur.

### Résumé

Un photodiode de la présente invention est définie selon la revendication 1.

Ainsi, un mode de réalisation prévoit une photodiode à éclairement par la face arrière, BSI, dans laquelle au moins une zone de la surface photoréceptrice de la photodiode comprend un évidement rempli d'un matériau d'indice optique inférieur à celui du matériau semiconducteur de la photodiode, ledit matériau d'indice optique inférieur étant transparent à la longueur d'onde de fonctionnement de la photodiode. Les dimensions latérales de la zone sont inférieures à la longueur d'onde de fonctionnement de la photodiode.

Selon un mode de réalisation, la zone a une forme annulaire. La surface photoréceptrice a des dimensions latérales de l'ordre de une à deux fois la longueur d'onde de fonctionnement.

Selon un mode de réalisation, le matériau semiconducteur est du silicium et le matériau d'indice optique inférieur est de l'oxyde de silicium.

Selon un mode de réalisation, la dimension latérale interne de l'anneau est comprise entre environ 200 et environ 500 nm et sa dimension latérale externe est comprise entre environ 450 et environ 650 nm pour une longueur d'onde de fonctionnement correspondant au rouge.

Un mode de réalisation prévoit un procédé de fabrication d'une photodiode telle que ci-dessus, comprenant une étape préalable de réalisation d'une simulation pour déterminer les dimensions des évidements en fonction des matériaux choisis et de la longueur d'onde de fonctionnement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement, en coupe, une partie d'un réseau de photodiodes de petites dimensions ;
la figure 2 représente très schématiquement, en coupe, une partie d'un réseau de photodiodes de petites dimensions muni de plots de diffraction ;
la figure 3 représente, en coupe, un mode de réalisation de pixels d'un réseau de photodiodes de petites dimensions selon l'invention ;
les figures 4A et 4B sont respectivement une vue en coupe et une vue de dessus agrandies d'une partie de la figure 3 ;
les figures 5A et 5B sont respectivement une vue en coupe et une vue de dessus agrandies d'une partie d'un mode de réalisation d'une variante de photodiode ; et
la figure 6 est un abaque illustrant le gain d'absorption dans une photodiode du type de celle des figures 5A et 5B par rapport au cas d'une photodiode du type de celle de la figure 1.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

La figure 2 représente une tentative d'amélioration de rendement quantique de chaque photodiode du réseau de photodiodes BSI de la figure 1. On y retrouve les mêmes éléments que ceux déjà représentés en figure 1, désignés par de mêmes références. En outre, on a ajouté, de la façon suggérée par la demande de brevet PCT WO2012032495, un plot 15 au-dessus de chaque photodiode. On pourrait s'attendre à retrouver les résultats avantageux d'augmentation du rendement quantique décrits dans cette demande de brevet. Toutefois, l'adoption d'une telle structure entraîne l'apparition d'un autre inconvénient. En effet, les filtres R, G, B, 9 doivent être déposés au-dessus d'une couche bien plane. Pour cela, au-dessus des plots 15, on dépose une couche de planarisation 18 dont l'épaisseur totale doit être supérieure à celle du plot pour assurer une planarisation satisfaisante. L'épaisseur de la couche de planarisation 18 est en pratique supérieure à 400 à 800 nm. La présence de cette couche 18 relativement épaisse entre les filtres et la surface supérieure des zones actives 1 des photodiodes, entraîne des problèmes de diaphotie, à savoir que de la lumière ayant traversé une lentille associée à un filtre d'une couleur donnée risque de se disperser latéralement dans la couche 18 et d'atteindre une région semiconductrice 1 normalement associée à un autre filtre. Ces problèmes de diaphotie sont d'autant plus aigus que les pixels sont petits.

D'autre part, la réalisation de structures de plots et de couches de planarisation sur la face arrière d'une photodiode BSI pose des problèmes de fabrication.

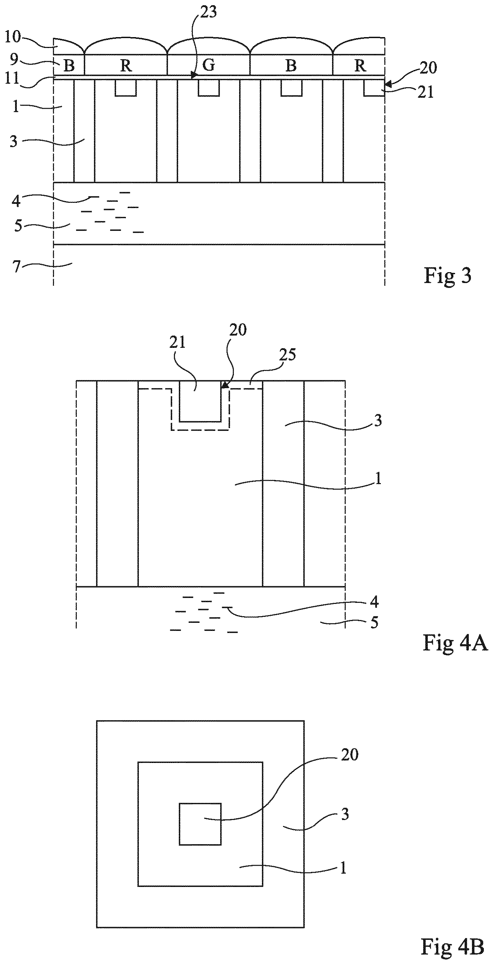

On retrouve en figure 3 les mêmes éléments qu'en figure 1, désignés par les mêmes références.

On rappellera à nouveau que la structure de photodiode 1 comprend diverses jonctions non représentées, formées à partir de la face avant de la structure, c'est-à-dire la face non éclairée du côté des niveaux d'interconnexions 4. Egalement, du côté de la face avant, divers transistors destinés à la connexion des photodiodes et à la lecture des charges qui y sont stockées à la suite d'un éclairement sont formés dans des portions de la région semiconductrice 1.

Dans le mode de réalisation de la figure 3, du côté de la face arrière des photodiodes 1, des évidements 20 à l'intérieur de chacun desquels est inséré un matériau 21 d'indice optique inférieur à l'indice optique du matériau semiconducteur 1 sont creusés dans la surface réceptrice 23 de chacune des photodiodes. Le matériau 21 est par exemple de l'oxyde de silicium dans le cas où le matériau semiconducteur 1 est du silicium. Toutefois, dans ce cas, tout matériau d'indice plus faible que celui du silicium pourra être utilisé, à condition qu'il soit transparent à la longueur d'onde de fonctionnement de la photodiode considérée.

Dans la réalisation de la figure 3, on a représenté des évidements 20 remplis de matériau 21 associés à chacune des photodiodes pour les trois couleurs R, G, B. En pratique, le problème le plus aigu se pose pour les photodiodes associées à des filtres rouges pour lesquelles la probabilité d'interaction entre un photon et le matériau semiconducteur pour former une paire électrons-trous est la plus faible. On pourra donc prévoir des évidements 20 remplis du matériau 21 seulement pour les photodiodes associées à la couleur rouge et pour des photodiodes associées à la détection de lumière infrarouge, s'il en est prévu.

Les figures 4A et 4B sont respectivement une vue en coupe et une vue de dessus agrandies d'une photodiode de la figure 3. On y retrouve le matériau semiconducteur 1 de la photodiode délimité par une région isolante périphérique 3. En bas de la figure (face avant non éclairée de la photodiode), se trouve le réseau d'interconnexions 4 noyé dans un isolant 5.

On voit dans ces figures que l'évidement 20 rempli du matériau 21 a en vue de dessus une forme sensiblement carrée. Cette forme sera de préférence arrondie, en couronne. De plus, en vue de dessus, la photodiode n'aura pas nécessairement une section carrée mais pourra avoir une forme arrondie, rectangulaire ou ovale.

On a également représenté en figure 4A, par une limite en pointillés, la limite d'une zone 25 dans laquelle est implanté, après formation de l'évidement, un dopant du même type de conductivité que le dopant du matériau semiconducteur 1 de la photodiode mais à plus fort niveau de dopage. Un tel dopage supplémentaire est destiné à limiter les problèmes de recombinaison des porteurs à l'interface entre la partie semiconductrice et un isolant qui la recouvre et contribue donc à réduire le courant d'obscurité de la photodiode.

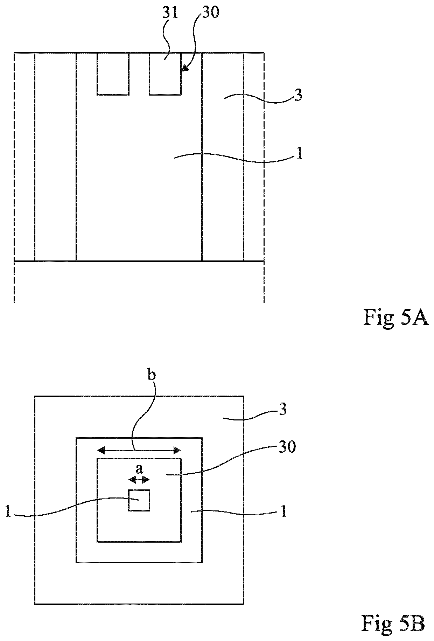

Les figures 5A et 5B sont des vues en coupe et de dessus similaires aux figures 4A et 4B. De mêmes éléments y sont désignés par de mêmes références. Dans cette réalisation, un évidement 30 contenant un matériau à haut indice 31 a une forme annulaire. Cette structure fournit un gain particulièrement net de rendement quantique de la photodiode.

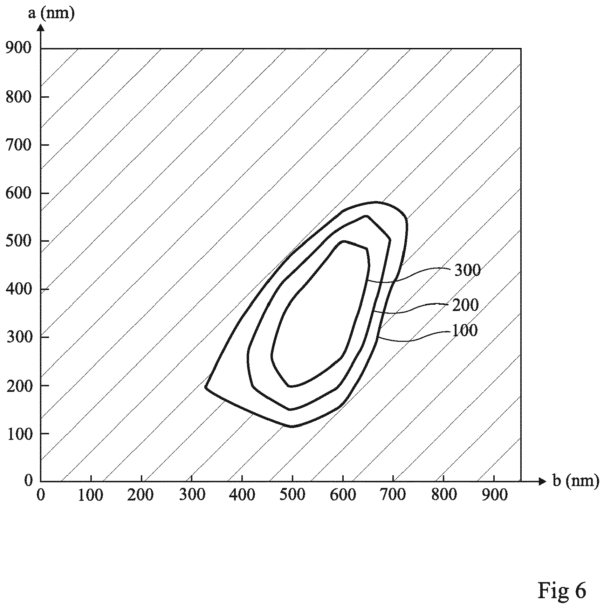

Si on désigne par a la dimension interne de l'anneau et par b la dimension externe de l'anneau, la figure 6 est un abaque indiquant, en fonction des valeurs a et b, l'absorption de lumière par une photodiode. L'abaque de la figure 6 est tracé dans le cas où le semiconducteur est du silicium d'une épaisseur de 3 µm et l'anneau 30 est rempli d'oxyde de silicium, la profondeur de l'évidement annulaire étant de 50 nm et pour une lumière rouge dont la longueur d'onde est de l'ordre de 600 nm.

Dans ces conditions, pour une photodiode telle que celle de la figure 1, munie d'une couche antireflet mais sans structure diffractante particulière, l'absorption est de 80,7 %. Pour une structure du type de celle des figures 5A et 5B, munie d'une couche antireflet, l'absorption devient, comme l'illustre la figure 6, supérieure à 81 % à l'intérieur d'une courbe 100, supérieure à 82 % à l'intérieur d'une courbe 200, et supérieure à 84 % à l'intérieur d'une courbe 300.

Ainsi, dans ce cas particulier, on voit que le gain d'absorption induit par l'anneau diffusant est maximum quand la dimension latérale interne de l'anneau est comprise entre environ 200 et environ 500 nm et que sa dimension latérale externe est comprise entre environ 450 et environ 650 nm.

De façon générale, l'homme de métier pourra obtenir l'abaque de la figure 6 et réaliser une optimisation des dimensions par des procédés classiques de simulation, en utilisant des programmes de simulation tels que le logiciel DiffractMOD (www.rsoftdesign.com) ou le logiciel Grating Toolbox (www.lighttrans.com). Ainsi, moyennant ce calcul de simulation préalable, l'homme de l'art pourra, sans tâtonnements, réaliser des anneaux diffractants de dimensions convenables pour augmenter le rendement quantique ou absorption de photons d'une photodiode.

Bien entendu, la présente invention est susceptible de nombreuses variantes et modifications en ce qui concerne notamment les matériaux utilisés qui peuvent être tous matériaux choisis, à condition qu'ils soient transparents à la longueur d'onde de fonctionnement et qu'ils respectent les relations d'indices exposées précédemment. Si la technologie amène à utiliser d'autres matériaux que du silicium et de l'oxyde de silicium, des programmes de simulation tels que ceux indiqués précédemment permettront de déterminer les dimensions optimales des anneaux à utiliser, sans tâtonnements.

Dans les diverses réalisations des figures 4A-4B et 5A-5B, l'évidement aura de préférence une profondeur comprise entre le cinquantième et la moitié de la longueur d'onde de fonctionnement de la photodiode.

## Revendications

1. Photodiode en un matériau semiconducteur à éclairement par la face arrière, BSI, dans laquelle la surface photoréceptrice a des dimensions latérales de l'ordre de une à deux fois la longueur d'onde de fonctionnement, et dans laquelle au moins une zone d'une surface photoréceptrice (23) du matériau semiconducteur de la photodiode comprend un évidement (20 ; 30) de dimensions latérales inférieures à la longueur d'onde de fonctionnement de la photodiode, rempli d'un matériau (21 ; 31) d'indice optique inférieur à celui du matériau semiconducteur de la photodiode, ledit matériau d'indice optique inférieur étant transparent à la longueur d'onde de fonctionnement de la photodiode, ladite photodiode étant de surcroît entourée de tranchées isolantes (3).

2. Photodiode selon la revendication 1, dans laquelle ladite zone a une forme annulaire (30).

3. Photodiode selon la revendication 1 ou 2, dans laquelle le matériau semiconducteur est du silicium et ledit matériau d'indice optique inférieur est de l'oxyde de silicium.

4. Photodiode selon l'une quelconque des revendications 1 à 3, dans laquelle la dimension latérale interne de l'anneau est comprise entre environ 200 et environ 500 nm et sa dimension latérale externe est comprise entre environ 450 et environ 650 nm pour une longueur d'onde de fonctionnement correspondant au rouge.

5. Procédé de fabrication d'une photodiode selon l'une quelconque des revendications 1 à 4, comprenant une étape préalable de réalisation d'une simulation pour déterminer les dimensions des évidements en fonction des matériaux choisis et de la longueur d'onde de fonctionnement.

## Patentansprüche

1. Eine Rückseitenbelichtungs-, BSI-Fotodiode aus einem Halbleitermaterial, wobei die lichtempfangende Oberfläche Querabmessungen in dem Bereich der einfachen bis doppelten Betriebswellenlänge besitzt, und wobei wenigstens ein Bereich der lichtempfangenden Oberfläche (23) des Halbleitermaterials der Fotodiode eine Ausnehmung (20; 30) von einer Querabmessung kleiner als die Betriebswellenlänge der Fotodiode aufweist, und mit einem Material (21; 31) gefüllt ist, das einen optischen Index niedriger als der des Halbleitermaterials der Fotodiode besitzt, wobei das Material mit niedrigerem optischem Index bei der Betriebswellenlänge der Fotodiode transparent ist, und wobei die Fotodiode zusätzlich von isolierenden Gräben (3) umgeben ist.

2. Fotodiode gemäß Anspruch 1, wobei der Bereich ringförmig (30) ist.

3. Fotodiode gemäß Anspruch 1 oder 2, wobei das Halbleitermaterial Silizium ist und das Material mit niedrigerem optischem Index Siliziumoxid ist.

4. Fotodiode gemäß einem der Ansprüche 1 bis 3, wobei die innere Querabmessung des Rings in dem Bereich zwischen ungefähr 200 und ungefähr 500 nm liegt und seine äußere Querabmessung in dem Bereich zwischen ungefähr 450 und ungefähr 650 nm für eine Betriebswellenlänge korrespondierend zu Rot liegt.

5. Verfahren zur Herstellung der Diode gemäß einem der Ansprüche 1 bis 4, das einen Vorsimulationsschritt zum Bestimmen der Dimensionen der Ausnehmungen gemäß den ausgewählten Materialien und der Betriebswellenlänge aufweist.

## Claims

1. A backside illumination, BSI, photodiode made of a semiconductor material, wherein the light-receiving surface has lateral dimensions in the range from once to twice the operating wavelength, and wherein at least one area of a light-receiving surface (23) of semiconductor material of the photodiode comprises a recess (20; 30) of lateral dimensions smaller than the operating wavelength of the photodiode, filled with a material (21; 31) having an optical index lower than that of the semiconductor material of the photodiode, said material of lower optical index being transparent to the operating wavelength of the photodiode, said photodiode being additionally surrounded with insulating trenches (3).

2. The photodiode of claim 1, wherein said area is ring-shaped (30).

3. The photodiode of claim 1 or 2, wherein the semiconductor material is silicon and said material of lower optical index is silicon oxide.

4. The photodiode of any of claims 1 to 3, wherein the internal lateral dimension of the ring is in the range between approximately 200 and approximately 500 nm and its external lateral dimension is in the range between approximately 450 and approximately 650 nm for an operating wavelength corresponding to red.

5. A method of manufacturing the photodiode of any of claims 1 to 4, comprising a prior simulation step to determine the dimensions of the recesses according to the selected materials and to the operating wavelength.
